# FASCICULE DE BREVET EUROPEEN

(11) **EP 0 402 188 B1**
(45) Date de publication et mention de la délivrance du brevet: **09.11.1994**
(21) Numéro de dépôt: 90401283.8
(22) Date de dépôt: 15.05.1990
(51) Int. Cl.: H01L 23/482

(54) **Composant à faible capacité en puce, notamment diode PIN en puce**
Chip-Baustein niedriger Kapazität, insbesondere PIN-Chip-Diode
Low capacity chip component, in particular PIN chip diode

(30) Priorité: 06.06.1989 FR 8907453
(43) Date de publication de la demande: 12.12.1990
(73) Titulaire: THOMSON-CSF, 75008 Paris (FR)
(72) Inventeur: Mur, Rémy, F-92045 Paris La Défense (FR)
(74) Mandataire: Albert, Claude

(56) Documents cités:
- DE-A- 3 421 482
- GB-A- 2 028 583
- US-A- 4 733 290

## Description

La présente invention concerne les composants semiconducteurs mesa à faible capacité et leurs montages sur un circuit d'utilisation.

L'invention s'applique notamment aux diodes PIN mesa à faible capacité telles que celles utilisées en hyperfréquences, et c'est principalement dans ce contexte que l'on exposera l'invention. Cet exemple n'a cependant aucun caractère limitatif, et l'invention pourrait s'appliquer aussi bien à la réalisation de composants semiconducteurs très divers, dès lors que l'on recherche, comme on va l'expliquer, à la fois une faible capacité parasite et une possibilité d'effectuer aisément et de façon très automatisée les opérations de report et de câblage.

Les diodes PIN mesa et composants analogues se présentent sous deux formes différentes, correspondant a deux technologies différentes, à savoir la technologie «en puce» et la technologie «*beam-lead*» (à micropoutres).

Lorsque le composant est conditionné en puce, son report sur le circuit où il doit être utilisé est, du fait de son conditionnement, très aisé et facile à industrialiser ; on dispose en effet de machines *pick-and-place* (de report) et de machines de câblage automatiques et relativement peu délicates a mettre en oeuvre, permettant de réaliser les différentes opérations nécessaires à une cadence soutenue et avec une très grande fiabilité.

En revanche, cette technique est mal adaptée aux composants mesa a faible capacité : en effet, la capacité propre du composant est directement proportionnelle a la surface du mesa, de sorte que si l'on veut des composants a faible capacité, on devra avoir un mesa de très faible diamètre (typiquement de l'ordre de 10 µm), sur le sommet duquel il deviendra très difficile de reporter un fil.

En effet, ce fil devra avoir un diamètre inférieur a celui du mesa, ce qui oblige a choisir un diamètre de fil de l'ordre de 8 ou 12 µm, valeurs pour lesquels ils n'existe pas de machines permettant un report automatisé sur le sommet du mesa. Le report devra donc être fait à la main, ce qui exclut toute automatisation complète de la fabrication du circuit, et reste en tout état de cause une opération très délicate compte tenu de la finesse extrême du fil.

C'est en raison de cette limitation que, pour les composants à faible capacité, on abandonne la technologie en puce au profit de la technologie beam-lead.

Cette dernière consiste à faire croître de manière sélective des micropoutres, le contact étant réalisé à l'extrémité distale de la micropoutre, que l'on peut rendre à cet endroit aussi large qu'on le souhaite.

La technologie beam-lead est par exemple utilisée dans le document DE-A-3421 482 pour la réalisation d'une diode Schottky à circuit RC intégré. Cette demande de brevet enseigne par ailleurs que la capacité parasite due à une micropoutre peut être réduite en plaçant, sous cette micropoutre, un substrat isolant.

La technique du beam-lead permet de réaliser avec excellente fiabilité des composants performants.

Elle présente cependant un certain nombre d'inconvénients :
- elle nécessite de nombreuses étapes supplémentaires (photolithographie, croissance des poutres, manipulation plus difficile des composants pour leur conditionnement), ce qui augmente le coût du composant ;
- une partie importante de la surface de silicium de la tranche est occupée uniquement par les poutres environnant le composant proprement dit, ce qui grève encore le coût du composant puisque, pour un même diamètre de tranche, on réalisera un nombre notablement inférieur de composants individuels que dans le cas des composants en puce ; cet inconvénient est en outre aggravé par le fait qu'il faut au moins deux poutres (une pour le contact d'anode au sommet du mesa, l'autre pour le contact ohmique de cathode au substrat), alors que dans le composant en puce le contact de cathode se fait directement au dos du composant ;
- son report sur le circuit est délicat, ce qui exclut de le faire par des machines automatiques à cadence élevée ;
- une fois monté sur le circuit, on ne dispose d'aucune marge d'élasticité (à la différence de la souplesse naturelle du fil de câblage des composants en puce), ce qui crée des difficultés si l'on veut monter le composant sur un circuit souple ou très dilatable ;

Le but de la présente invention est de proposer un composant en puce à faible capacité qui pallie les inconvénients précités des composants en puce connus, sans pour autant présenter les limitations de la technologie *beam-lead*. Ce but est atteint par un composant selon la revendication 1 et les montages d'un tel composant sur un circuit d'utilisation tel que définis dans les revendications 8 et 9.

Plus précisément, et comme on le verra en détail par la suite, le composant en puce de l'invention est conçu pour :
- permettre un report et un câblage aisés et très industrialisés pardes machines automatiques à cadence élevée ;
- présenter une dimension de composant du même ordre que les composants en puce classiques, ce qui permettra d'en réaliser un nombre élevé sur une même tranche ;
- permettre un diamètre de mesa aussi réduit qu'on le souhaite, ce qui permet de réaliser des diodes de très faible capacité propre ;
- présenter une faible inductance de connexion, notamment dans certains modes de réalisation particuliers que l'on exposera ;
- présenter, une fois monté, une souplesse permettant son utilisation sur des substrats déformables et/ou très dilatables.

L'invention s'applique, comme on l'a indiqué, aux composants mesa à faible capacité en puce, c'est-à-dire comportant un mesa formé à la surface d'un substrat semiconducteur, le substrat correspondant à une première électrode et le sommet du mesa correspondant à une seconde électrode du composant.

Des variantes avantageuses du composant sont définies dans les revendications 2 à 7.

On va maintenant décrire des exemples détaillés de réalisation de l'invention, en référence aux dessins annexés.

La figure 1 est une vue en coupe, selon I-I de la figure 2, d'une diode PIN réalisée selon les enseignements de l'invention.

La figure 2 est une vue en plan, selon II-II de la figure 1, de ce même composant.

La figure 3 montre le composant des figures 1 et 2, reporté sur un circuit et câblé à celui-ci.

La figure 4 est une variante de la figure 1, présentant une capacité parasite de liaison plus faible.

La figure 5 est une variante de la figure 1, destinée à permettre un montage *flip-chip*.

La figure 6 montre le composant de la figure 5 reporté sur son circuit.

Les figures 7 à 12 illustrent les différentes étapes de réalisation du composant de la figure 1.

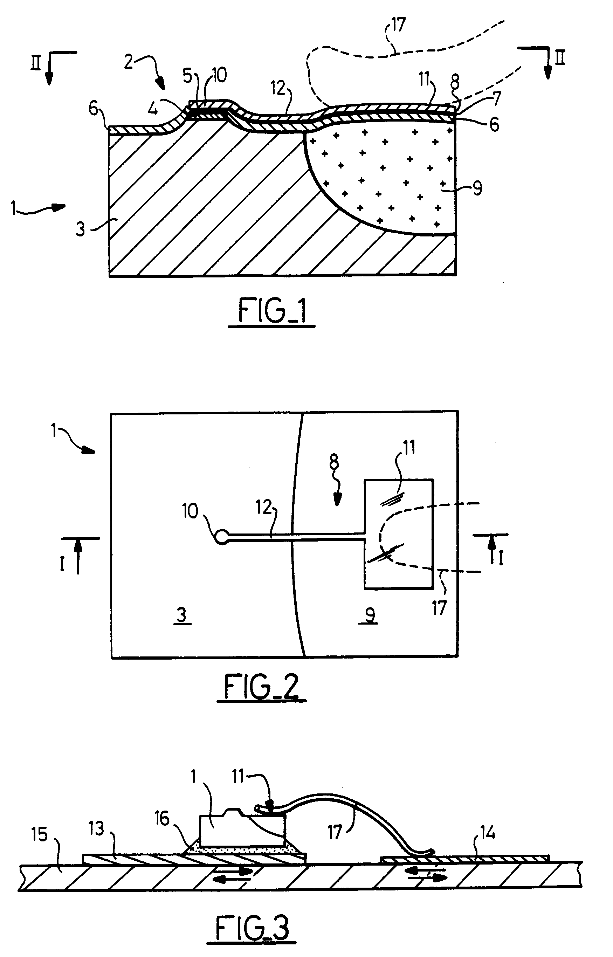

Les figures 1 et 2 montrent une diode PIN 1 comportant un mesa 2 formé à la surface d'un substrat semiconducteur 3, par exemple en silicium (ce matériau n'est pas limitatif ; la structure de l'invention s'applique aussi bien à d'autres semiconducteurs, par exemple GaAs).

Le substrat 3 est en silicium dopé N et forme la cathode de la diode (si l'on voulait inverser les électrodes, c'est-à-dire avec l'anode au substrat, on prendrait pour celui-ci un silicium dopé P). La base du mesa est constituée par un prolongement en saillie du substrat de silicium 3, surmonté par une couche semiconductrice intrinsèque 4 et une couche semiconductrice 5 dopée P permettant de réaliser la structure PIN. L'ensemble est revêtu, à l'exception du sommet du mesa, d'une couche de passivation 6.

La connexion de cathode est réalisée directement par contact sur le dos du substrat 3, tandis que la connexion d'anode est prise sur le sommet du mesa par une liaison conductrice 8 déposée sur la couche de passivation 6 avec interposition, de manière en elle-même connue, d'une couche d'accrochage 7.

La liaison 8 se compose, comme on peut le voir notamment figure 2, d'une région 10 assurant la prise de connexion sur le sommet du mesa et sensiblement de même diamètre que celui-ci, d'un plot de câblage 11 de grandes dimensions sur lequel on viendra souder le fil de connexion 17, et d'une piste étroite 12 reliant les régions 10 et 11.

Dans la région du plot de câblage 11, et au moins partiellement dans la région de la piste 12, le substrat semiconducteur 3 a été remplacé par un substrat isolant à faible constante diélectrique 9, par exemple un verre marié en dilatation au silicium.

Le rôle de ce substrat à faible constante diélectrique est de réduire au minimum la capacité parasite dûe à la liaison conductrice 11,12. C'est pourquoi la dimension de la zone 9 est de préférence telle que la majeure partie de la piste 12 se trouve au-dessus du verre, puisque c'est essentiellement la surface, donc la longueur, de la fraction de piste s'étendant au-dessus du substrat semiconducteur 3 qui déterminera la capacité parasite de connexion qui viendra s'ajouter à la capacité propre du mesa.

Le composant ainsi réalisé a par exemple une dimension hors-tout de 200 µm x 300 µm, avec un plot de câblage 11 de 70 µm x 100 µm. Le diamètre du mesa (et donc de la région 10) peut être aussi faible que 10 µm.

Avec ces dimensions, on voit que l'on pourra sans difficulté souder sur le plot de câblage 11 un fil 17 de diamètre très supérieur au diamètre du mesa, par exemple un fil de 25 µm de diamètre alors que le mesa n'a une dimension que de 10 µm.

La figure 3 illustre le composant reporté et câblé sur son circuit.

Ce circuit comporte par exemple deux pistes 13, 14 cuivrées formée sur un substrat 15. Le dos du composant 1 (contact de cathode) est relié mécaniquement et électriquement à la piste 13 par une brasure ou un collage 16, tandis que le contact d'anode, pris sur le plot de câblage 11, est réalisé par un fil 17 (qui peut être, comme on l'a indiqué, de diamètre relativement important) raccordé au plot de câblage 11 et à la piste 14 par des méthodes traditionnelles telles que soudage par ultrasons, thermocompression ou soudage thermosonique.

Ces différentes opérations pourront être réalisées aisément, de façon entièrement automatique et à cadence élevée par des machines classiques prévues pour le report et le câblage des composants en puce.

On voit en outre que le fil 17 apporte un élément de souplesse important qui permettra au montage de résister sans aucune difficulté à toute les dilatations (schématisées par des flèches) ou autres déformations du substrat 15, comme c'est en particulier le cas lorsque l'on utilise des supports flexibles.

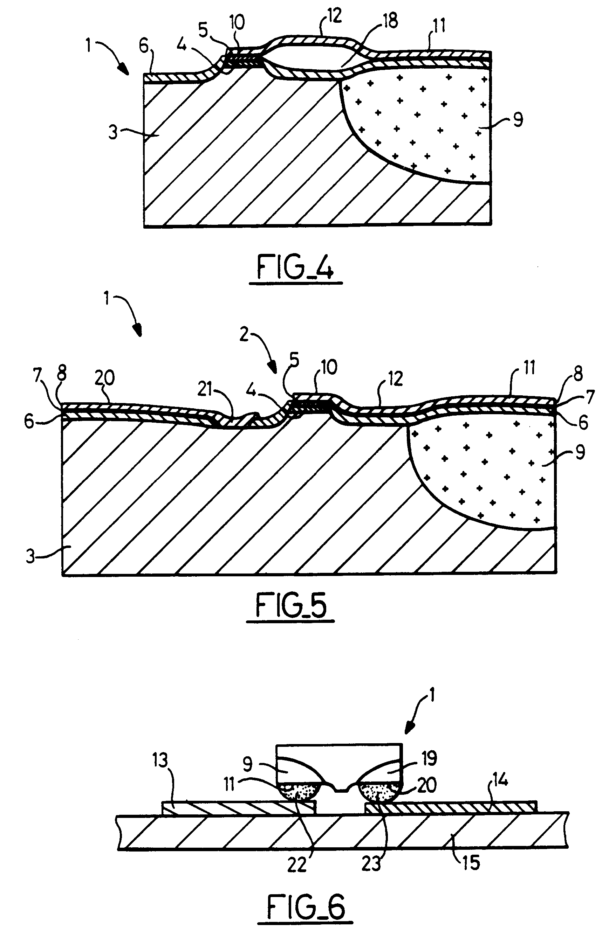

Sur la figure 4, on a illustré une variante dans laquelle la piste 12 des figures 1 et 2, qui était formée à la surface du composant, est remplacée par un «pont à air» de manière à ne présenter qu'une capacité parasite résiduelle extrêmement faible (cette capacité parasite ne résultant alors plus essentiellement que de la capacité propre du mesa).

Dans cette technique du «pont à air», qui est en elle-même connue, la liaison conductrice 12 n'est plus formée à la surface du composant mais au-dessus et à distance de celle-ci, cet intervalle (de l'ordre de 1 à 2 µm) étant obtenu par application à cet endroit d'une résine épaisse qui disparaîtra au développement et laissera subsister un vide d'air 18.

Cette technique, qui permet de réduire de façon importante la capacité parasite du composant, est en revanche plus coûteuse à réaliser (et nécessite une étape supplémentaire pour l'application de la résine épaisse) et aboutit à un composant plus fragile. Il peut cependant être indispensable de la mettre en oeuvre lorsque l'on recherche des performances extrêmes.

Les figures 5 et 6 sont homologues des figures 1 et 3 pour une variante destinée à un montage *flip-chip* (montage «à la retourne») de la diode sur son circuit.

Du fait que l'on retourne le composant pour le monter, il n'est plus possible de prendre un contact de cathode sur le dos du substrat. On forme alors un contact ohmique spécifique similaire au plot de câblage d'anode 11, un plot de câblage de cathode 20 relié à un contact ohmique 21 directement en contact avec le substrat 3.

Le composant, qui comporte alors deux plots de câblage, est monté de la manière illustrée figure 6, les deux plots de câblage 11 et 20 étant reliés aux pistes 13 et 14 par l'intermédiaire de *bumps* (tampons) 22 et 23 en métal ou alliage à faible température de fusion (or, étain, plomb, indium, etc. ou leurs alliages) soudés par refusion ou thermocompression.

On voit que, dans ce mode de montage, on s'affranchit de l'inductance parasite du fil 17 de la figure 3, ce qui permet d'avoir à la fois faible capacité et faible inductance parasites. En revanche, on ne bénéficie plus de la souplesse naturelle du fil comme dans le cas de la figure 3.

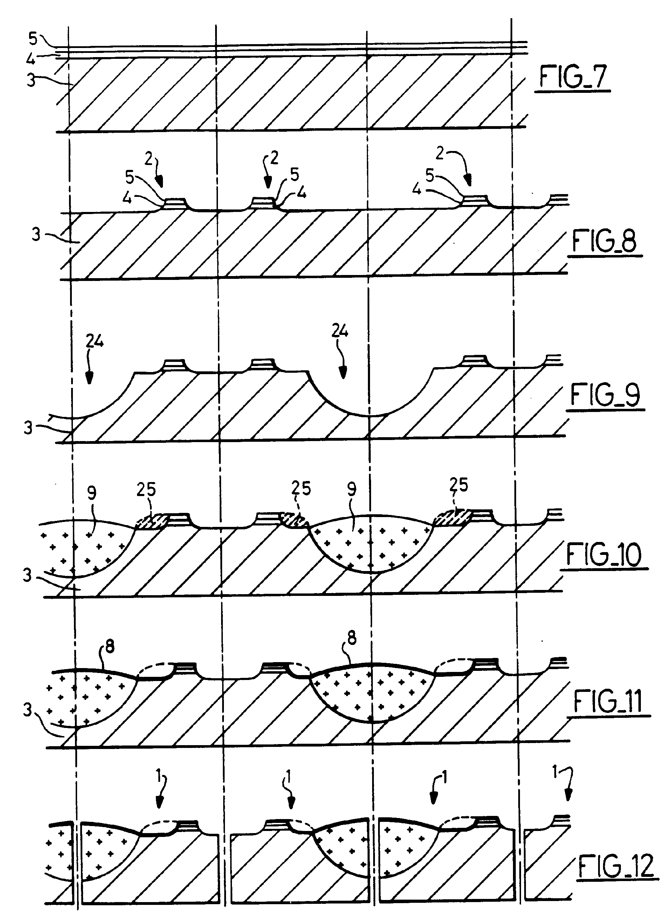

Les figures 7 à 12 montrent schématiquement les différentes étapes du processus de fabrication d'un composant selon l'invention tel que celui illustré figure 1.

Tout d'abord (figure 7), on fait croître ou on implante sur un substrat N 3 les couches 4 et 5 (intrinsèque et P) destinées à former la structure PIN. Ces couches sont réalisées de manière classique, par exemple par implantation ionique, dopage biphase ou épitaxie.

Ensuite (figure 8), on individualise les différents mesa 2 par attaque chimique sélective.

L'étape suivante (figure 9) consiste à creuser, également par attaque chimique, les zones de vitrification 24 à l'endroit où seront situés les plots de liaison. Ces zones sont formées, de manière en elle-même classique, par masquage et attaque chimique sélective.

On remplit ensuite (figure 10) les zones de vitrification 24 ainsi formées par un verre 9, par exemple un verre SOG en poudre marié en dilatation au silicium du substrat 3. On effectue alors la cuisson du verre en température. On réalise également à ce stade le dépôt de la couche de passivation 6, qui recouvre l'ensemble du composant, y compris les flancs du mesa mais à l'exception du sommet de celui-ci.

Si l'on choisit la variante de la figure 4 (liaison par pont à air), on procède également au dépôt de la résine épaisse 25 qui permettra de réaliser la connexion surmontant le substrat.

L'étape suivante (figure 11) permet de réaliser le contact ohmique d'anode par dépôt général d'une métallisation d'or (précédée des dépôts des couches d'accrochage classiques nécessaires), puis par gravure sélective dans la couche d'or 8 des différentes parties métalliques 10, 11, 12 de la figure 2.

La tranche est ensuite sciée pour individualiser les composants 1 (figure 12). Le cas échéant, les composants peuvent être livrés sur une «peau de tambour» sur laquelle ils auront été directement reportés, ce conditionnement étant parfaitement adapté aux machines de report automatique des composants en puce.

## Revendications

1. Un composant semiconducteur à faible capacité, en technologie en puce (1), comportant un mesa (2) formé à la surface d'un substrat semiconducteur (3), le substrat constituant une première électrode du composant et le sommet du mesa correspondant à une seconde électrode du composant, une couche de passivation (6) étant disposée sur toute ladite surface à l'exception du sommet du mesa (2), ledit substrat comportant, du côté de ladite surface, une première partie latérale substituée par un autre substrat (9) isolant et de faible constante diélectrique, et le composant comportant en outre un plot de câblage (11) qui forme une région de prise de connexion ayant des dimensions plus grandes que le diamètre du mesa (2), formé sur la couche de passivation (6) au-dessus dudit substrat (9) isolant et relié électriquement au sommet du mesa par une liaison conductrice étroite (12) dont la largeur est inférieure au diamètre du mesa (2).

2. Le composant de la revendication 1, caractérisé en ce que le matériau dudit substrat isolant et de faible constante diélectrique (9) est un verre.

3. Le composant de l'une des revendications 1 et 2, caractérisé en ce qu'il constitue une diode PIN en puce.

4. Le composant de l'une des revendications 1 à 3, caractérisé en ce que la majeure partie de la liaison conductrice étroite (12) se trouve au-dessus dudit substrat (9) isolant.

5. Le composant de l'une des revendications 1 à 4, caractérisé en ce que la liaison conductrice étroite (12) est une piste formée sur la couche de passivation (6).

6. Le composant de l'une des revendications 1 à 4, caractérisé en ce que la liaison conductrice étroite (12) est une connexion en pont à air formée au-dessus de la couche de passivation (6) et à distance de celle-ci.

7. Le composant de l'une des revendications 1 à 6, caractérisé en ce qu'il comporte sur une seconde partie latérale, opposée à la première partie latérale par rapport au mesa, une seconde région de prise de connexion (19) comprenant en surface et sur la couche de passivation (6) un second plot de câblage (20) relié électriquement au substrat semiconducteur (3) par un contact ohmique (21).

8. Montage du composant en puce de l'une des revendications 1 à 6 sur un circuit d'utilisation, caractérisé en ce qu'une connexion entre le plot de câblage (11) et une première piste (14) du circuit d'utilisation est réalisée par un fil (17) de diamètre notablement supérieur au diamètre du mesa que l'on vient reporter sur le plot de câblage (11), la connexion à l'autre électrode étant réalisée par report du composant avec contact direct du dos du substrat sur une seconde piste (13) du circuit d'utilisation.

9. Montage du composant en puce de la revendication 7 sur un circuit d'utilisation, caractérisé en ce que les connexions entre les plots de câblage (11, 20) et des pistes (13, 14) du circuit d'utilisation sont réalisées par montage flip-chip de la puce sur lesdites pistes (13, 14).

## Patentansprüche

1. Kapazitätsarmes Halbleiterbauelement in Chipbauweise (1) mit einer Mesafläche (2), die auf der Oberfläche eines Halbleitersubstrats (3) ausgebildet ist, wobei das Substrat eine erste Elektrode des Bauelements bildet und die Mesafläche einer zweiten Elektrode des Bauelements entspricht, wobei eine Passivierungsschicht (6) auf die ganze Oberfläche mit Ausnahme der Mesafläche (2) aufgebracht ist, wobei das Substrat auf der Seite seiner Oberfläche einen ersten seitlichen Bereich aufweist, in dem es durch ein anderes, isolierendes Substrat (9) mit geringer Dielektrizitätskonstante ersetzt ist, und wobei das Bauelement weiter einen Anschlußfleck (11) aufweist, der eine Anschlußzone mit größeren Abmessungen als der Durchmesser der Mesafläche (2) bildet und der auf der Passivierungsschicht (6) oberhalb des isolierenden Substrats (9) ausgebildet sowie elektrisch mit der Mesafläche über eine schmale leitende Verbindung (12) verbunden ist, deren Breite geringer als der Durchmesser der Mesafläche (2) gewählt ist.

2. Bauelement nach Anspruch 1, dadurch gekennzeichnet, daß das Material des isolierenden Substrats mit niedriger Dielektrizitätskonstante (9) ein Glas ist.

3. Bauelement nach einem der Ansprüche 1 und 2, dadurch gekennzeichnet, daß es eine PIN-Diode in Chipbauweise bildet.

4. Bauelement nach einem der Ansprüche 1 bis 3, dadurch gekennzeichnet, daß der größte Teil der schmalen leitenden Verbindung (12) sich oberhalb des isolierenden Substrats (9) befindet.

5. Bauelement nach einem der Ansprüche 1 bis 4, dadurch gekennzeichnet, daß die schmale leitende Verbindung (12) eine Leitbahn ist, die auf der Passivierungsschicht (6) ausgebildet ist.

6. Bauelement nach einem der Ansprüche 1 bis 4, dadurch gekennzeichnet, daß die schmale leitende Verbindung (12) ein Luftbrückenanschluß ist, der oberhalb der Passivierungsschicht (6) und in Abstand zu dieser ausgebildet ist.

7. Bauelement nach einem der Ansprüche 1 bis 6, dadurch gekennzeichnet, daß es in einem zweiten seitlichen Bereich, der dem ersten seitlichen Bereich hinsichtlich der Mesafläche gegenüberliegt, eine zweite Anschlußzone (19) aufweist, die auf der Oberfläche und auf der Passivierungsschicht (6) einen zweiten Anschlußfleck (20) besitzt, der elektrisch mit dem Halbleitersubstrat (3) über einen ohm'schen Kontakt (21) verbunden ist.

8. Montage des Chipbauelements gemäß einem der Ansprüche 1 bis 6 auf einer Schaltung, dadurch gekennzeichnet, daß eine Verbindung zwischen dem Anschlußfleck (11) und einem ersten Leiter (14) der Schaltung mit Hilfe eines Drahts (17) erfolgt, dessen Durchmesser deutlich größer als der der Mesafläche ist und der auf den Anschlußfleck (11) aufgebracht wird, wobei die Verbindung an der anderen Elektrode durch Aufbringen des Bauelements mit direktem Kontakt der Rückseite des Substrats auf einen zweiten Leiter (13) der Schaltung erfolgt.

9. Montage des Chipbauelements gemäß Anspruch 7 auf einer Schaltung, dadurch gekennzeichnet, daß die Verbindungen zwischen den Anschlußflecken (11, 20) und den Leitern (13, 14) der Schaltung durch Flip-Chip-Montage des Bauelements auf den Leitern (13, 14) erfolgt.

## Claims

1. A low-capacitance semiconductor component in chip technology (1), including a mesa (2) formed at the surface of a semiconductor substrate (3), the substrate constituting a first electrode of the component and the peak of the mesa corresponding to a second electrode of the component, a passivation layer (6) being arranged over the whole of the said surface with the exception of the peak of the mesa (2), the said substrate including, on the same side as the said surface, a first lateral part substituted by another insulating substrate (9) of low dielectric constant, and the component further including a wiring land (11) which forms a connection-fixing region having dimensions larger than the diameter of the mesa (2), formed on the passivation layer (6) above the said insulating substrate (9) and linked electrically to the peak of the mesa by a narrow conductor link (12), the width of which is less than the diameter of the mesa (2).

2. The component of claim 1, characterized in that the material of the said insulating substrate of low dielectric constant (9) is a glass.

3. The component of one of claims 1 and 2, characterized in that it constitutes a PIN chip diode.

4. The component of one of claims 1 to 3, characterized in that the major part of the narrow conductor link (12) is above the said insulating substrate (9).

5. The component of one of claims 1 to 4, characterized in that the narrow conductor link (12) is a track formed on the passivation layer (6).

6. The component of one of claims 1 to 4, characterized in that the narrow conductor link (12) is an air bridge connection formed above the passivation layer (6) and at a distance from the latter.

7. The component of one of claims 1 to 6, characterized in that it includes, on a second lateral part, opposite the first lateral part with respect to the mesa, a second connection-fixing region (19) comprising, at the surface and on the passivation layer (6) a second wiring land (20) electrically linked to the semiconductor substrate (3) via an ohmic contact (21).

8. Mounting of the chip component of one of claims 1 to 6 on a user circuit, characterized in that a connection between the wiring land (11) and a first track (14) of the user circuit is produced by a wire (17) of diameter significantly greater than the diameter of the mesa which is fixed to the wiring land (11), the connection to the other electrode being produced by fixing of the component with direct contact of the back of the substrate on a second track (13) of the user circuit.

9. Mounting of the chip component of claim 7 on a user circuit, characterized in that the connections between the wiring lands (11, 20) and the tracks (13, 14) of the user circuit are produced by flip-chip mounting of the chip on the said tracks (13, 14).
